# EUROPÄISCHE PATENTSCHRIFT

(11) **EP 1 342 316 B1**
(45) Veröffentlichungstag und Bekanntmachung des Hinweises auf die Patenterteilung: **11.08.2004**
(21) Anmeldenummer: 01995540.0
(22) Anmeldetag: 27.11.2001
(51) Int. Cl.: H03G 5/22

(54) **WIEDERGABEVORRICHTUNG FÜR ÜBER POTENTIELL STÖRBEHAFTETE KANÄLE ÜBERMITTELTE AUDIOSIGNALE**
PLAYBACK DEVICE FOR AUDIO SIGNALS THAT ARE TRANSMITTED OVER POTENTIALLY DISTURBED CHANNELS
DISPOSITIF DE RESTITUTION POUR DES SIGNAUX AUDIO TRANSMIS PAR DES VOIES POTENTIELLEMENT PERTURBEES

(30) Priorität: 05.12.2000 DE 10060296
(43) Veröffentlichungstag der Anmeldung: 10.09.2003
(73) Patentinhaber: ROBERT BOSCH GMBH, 70442 Stuttgart (DE)
(72) Erfinder: JANDEL, Peter, 31139 Hildesheim (DE); PITZ, Gerhard, 31139 Hildesheim (DE)
(86) Internationale Anmeldenummer: PCT/DE2001/004465
(87) Internationale Veröffentlichungsnummer: WO 2002/047261

(56) Entgegenhaltungen:
- US-A- 3 983 505
- US-A- 4 476 571
- PATENT ABSTRACTS OF JAPAN vol. 012, no. 476 (E-693), 13. Dezember 1988 (1988-12-13) & JP 63 194438 A (ALPINE ELECTRON INC), 11. August 1988 (1988-08-11)

## Beschreibung

### Stand der Technik

Die Erfindung geht von einer Wiedergabevorrichtung für über potentiell störbehaftete Kanäle übermittelte Audiosignale nach der Gattung des unabhängigen Patentanspruchs aus.

Wiedergabevorrichtungen für über potentiell störbehaftete Kanäle übermittelte Audiosignale sind beispielsweise in Form von Autoradios, die in empfangenen Rundfunksignalen enthaltene Audiosignale über angeschlossene Lautsprecher wiedergeben, grundsätzlich bekannt. Heutige Autoradios verfügen in der Regel über eine Klangbeeinflussungseinrichtung, beispielsweise in Form eines Bass- und eines Höhenstellers zur frequenzselektiven Verstärkung nieder- und hochfrequenter Anteile des wiederzugebenden Audiosignals, oder eines Equalizers, der eine gezielte frequenzbandspezifische Verstärkungseinstellung ermöglicht. Da sich Störungen eines empfangenen Rundfunksignals auch auf das wiederzugebende Audiosignal in Form von hörbaren Störungen, insbesondere im Bereich hochfrequenter Anteile des Audiosignals, auswirken, verfügen moderne Autoradios darüber hinaus über eine störabhängige Höhenabsenkung. Diese wird in der Fachliteratur häufig als High-Cut bezeichnet.

Solche Autoradios, bei denen eine High-Cut-Funktion in Abhängigkeit einer Feldstärke eines empfangenen Rundfunksignals realisiert ist, sind beispielsweise aus der Zeitschrift Autohifi, Heft 4/2000, Seite 22 und folgende bekannt.

Bei derzeit verfügbaren Autoradiogeräten ist die beschriebene High-Cut-Funktion unabhängig von einer Equalizer- oder Klangstellereinstellung. Im Falle einer durch den Höhensteller oder den Equalizer angehobenen Verstärkung hochfrequenter Anteile des wiederzugebenden Audiosignals bewirkt somit die High-Cut-Funktion im Falle eines gestörten Rundfunkempfangs eine unter Umständen nicht ausreichende Gesamtdämpfung der hochfrequenten Anteile des Audiosignals, so dass sich die insbesondere auf die hochfrequenten Anteile des Audiosignals auswirkenden Empfangsstörungen trotz High-Cut in störender Weise bemerkbar machen. Umgekehrt bewirkt High-Cut als Reaktion auf Empfangssignalstörungen in Verbindung mit einer an der Klangbeeinflussungseinrichtung voreingestellten Höhenabsenkung unter Umständen eine zu starke Gesamtabsenkung der hochfrequenten Anteile des Audiosignals, die zur Verdeckung der Empfangsstörungen nicht erforderlich wäre.

### Vorteile der Erfindung

Die erfindungsgemäße Vorrichtung mit den Merkmalen des unabhängigen Patentanspruchs hat demgegenüber den Vorteil, die vorgenannten Nachteile zu beseitigen.

Dies wird durch eine Wiedergabevorrichtung für über potentiell störbehaftete Kanäle übermittelte Audiosignale mit einer Einrichtung zur Erfassung eines Störgrades der Audiosignale, einer Einrichtung zur Absenkung hochfrequenter Anteile der Audiosignale in Abhängigkeit des Störgrades und einer Klangbeeinflussungseinrichtung zur frequenzselektiven Verstärkung der Audiosignale erreicht, die sich erfindungsgemäß durch eine Ausbildung der Absenkungsvorrichtung zur Absenkung der hochfrequenten Audiosignalanteile zusätzlich in Abhängigkeit einer mittels der Klangbeeinflussungseinrichtung voreingestellten frequenzselektiven Audiosignalverstärkung auszeichnet.

Vorteilhafte Ausgestaltungen und Weiterbildungen der Erfindung sind in den abhängigen Patentansprüchen angegeben.

So ist es von besonderem Vorteil, die Absenkungseinrichtung derart auszugestalten, dass eine durch die Klangbeeinflussungseinrichtung und die Absenkungsvorrichtung bestimmte Verstärkung des Audiosignals im Bereich der durch die Absenkungsvorrichtung beeinflussten Frequenzanteile auf ein allein durch den erfassten Störgrad vorgegebenes Maß eingestellt wird.

Hier wird also eine durch einen Equalizer oder einen Höhensteller voreingestellte Höhenanhebung oder -Absenkung für das Maß des je nach Störgrad erforderlichen High-Cut, also das Maß der störabhängig erforderlichen Dämpfung hochfrequenter Anteile des Audiosignals, berücksichtigt. Damit wird der im Abschnitt Stand der Technik beschriebene nachteilige Effekt eines nicht ausreichenden oder überzogenen High-Cut im Falle einer vorgewählten Höhenanhebung oder -Absenkung vermieden.

### Zeichnungen

Ausführungsbeispiele der Erfindung sind in den Figuren dargestellt und werden nachfolgend näher erläutert.

Es zeigen
Figur 1 eine erfindungsgemäße Audiosignalwiedergabevorrichtung am Beispiel eines Autoradios und
Figuren 2A, 2B und 2C mittels der erfindungsgemäßen Wiedergabevorrichtung beeinflusster Frequenzgänge zur Erläuterung der Wirkungsweise der Erfindung.

### Beschreibung der Ausführungsbeispiele

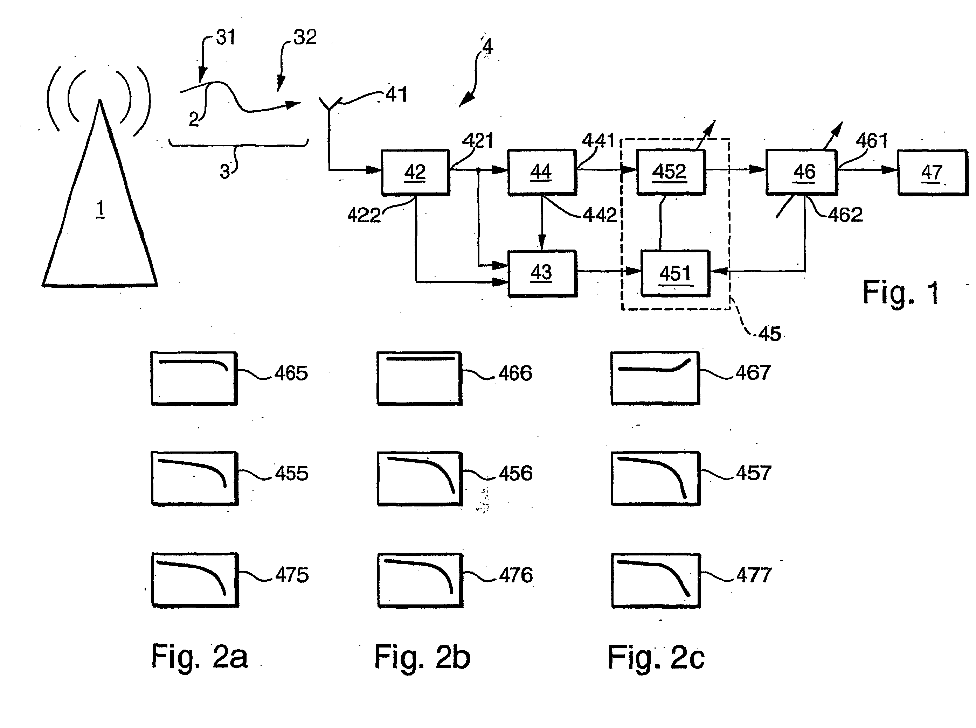

Die erfindungsgemäße Audiosignalwiedergabevorrichtung wird nachfolgenden am Beispiel eines Autoradios erläutert, das zum Empfang von Rundfunksignalen und zur akustischen Wiedergabe von in den empfangenen Rundfunksignalen enthaltenen Audiosignalen ausgelegt ist. Ein solches Autoradio ist in Figur 1 dargestellt.

Ein Rundfunksender 1 strahlt ein Rundfunksignal 2 in Form einer elektromagnetischen Welle ab. Das Rundfunksignal 2 besteht aus einer Trägerfrequenz, die im Falle von UKW-Rundfunk durch ein sogenanntes Stereo-Multiplexsignal (MPX), das sowohl ein Audiosignal, als auch digitale Daten umfasst, moduliert ist.

Das Rundfunksignal 2 wird über einen Übertragungskanal 3, im Falle eines Autoradios als erfindungsgemäßer Audiosignalwiedergabevorrichtung über das Medium Luft, übertragen. Die Übertragung des Rundfunksignals über den Übertragungskanal 3 kann Störungen 31, 32, wie beispielsweise Verzerrungen infolge Reflexionen und Abschattungen des Rundfunksignals, unterliegen.

Das über einen potentiell gestörten Übertragungskanal 3 übertragene Rundfunksignal, sowie weitere, von anderen Rundfunksendern abgestrahlte Rundfunksignale, stehen als Trägerfrequenzgemisch an einer Empfangsantenne 41 eines erfindungsgemäßen Autoradios 4 an. Das Antennensignal ist einem Empfangsteil 42 des Autoradios zugeführt, das aus dem an der Antenne 41 anstehenden Tragerfrequenzgemisch eine gewünschte Trägerfrequenz auswählt und diese zur Gewinnung der der Trägerfrequenz aufmodulierten Informationen, nämlich des Audiosignals und des digitalen Datensignals demoduliert. Das demodulierte und ins Basisband herabgemischte MPX-Signal ist an einem ersten Ausgang 421 des Empfangsteils 42 abnehmbar. An einem zweiten Ausgang 422 des Empfangsteils 42 steht ein die Empfangsfeldstärke des empfangenen Rundfunksignals anzeigendes Feldstärkesignal an.

Das MPX-Signal ist einem Stereodecoder 44 zugeführt, der aus den im MPX-Signal enthaltenen Audiosignalinformationen die Audiosignale für den linken und den rechten Stereokanal bildet. Die Audiosignale für den linken und rechten Stereokanal sind an einem ersten Ausgang 441 des Stereodecoders 44 abnehmbar. An einem zweiten Ausgang 442 des Stereodecoders 44 ist ein die Symmetrie der Seitenbänder des im MPX-Signal enthaltenen Stereo-Hilfsträgers anzeigendes Symmetriesignal abnehmbar.

Die am ersten Ausgang 441 des Stereodecoders 44 abnehmbaren Audiosignale für den linken und rechten Stereokanal sind einem steuerbaren Filter 452 zugeführt. Das steuerbare Filter 452 ist in Form eines hinsichtlich seiner Grenzfrequenz und seines Dämpfungsgrads steuerbaren Tiefpasses ausgeführt und dient in Verbindung mit einer nachfolgend näher beschriebenen Filtersteuerung 451 als Absenkungseinrichtung 45 zur Absenkung hochfrequenter Anteile der Audiosignale in Abhängigkeit des Störgrades des empfangenen Audiosignals.

Das am Ausgang des steuerbaren Filters 452 abnehmbare Audiosignal für den linken und rechten Stereokanal ist weiterhin einer an sich bekannten Klangbeeinflussungseinrichtung 46 zugeführt, die beispielsweise in Form eines kombinierten oder getrennten Höhen- und Bassstellers oder Vorzugsweise eines sogenannten Equalizers ausgeführt ist. Die Klangbeeinflussungseinrichtung dient der Vorgabe eines Amplitudenfrequenzgangs für das wiederzugebende Audiosignal und damit der Anpassung der Audiosignalwiedergabe an die Hörgewohnheiten oder Vorlieben des Hörers oder sich durch den Fahrzeuginnenraum ergebende akustische Besonderheiten, wie insbesondere Resonanzen.

Das an einem ersten Ausgang 461 der Klangbeeinflussungseinrichtung 46 abnehmbare Audiosignal für den linken und den rechten Stereokanal ist einer abschließenden Wiedergabestufe 47 zugeführt, die in an sich bekannter und daher nicht näher ausgeführter Weise über eine NF-Endstufe und daran angeschlossene Lautsprecher für den linken und den rechten Stereokanal verfügt.

An einem zweiten Ausgang 462 der Klangbeeinflussungseinrichtung 46 ist ein den an der Klangbeeinflussungseinrichtung eingestellten Amplitudenfrequenzgang kennzeichnendes Frequenzgangsignal abnehmbar, das der Filtersteuerung 451 der Absenkungseinrichtung 45 zugeführt ist. Der Filtersteuerung 451 der Absenkungseinrichtung 45 ist weiterhin ein Störsignal, das von einer Einrichtung 43 zur Erkennung des Störgrads des empfangenen Audiosignals gebildet ist, zugeführt. Der Störgraderkennungsschaltung 43 ist das am zweiten Ausgang 422 des Empfangsteils 42 anstehende Feldstärkesignal, desweiteren das MPX-Signal und schließlich das am zweiten Ausgang 442 des Stereodecoders 44 anstehende Symmetriesignal zugeführt. Das Symmetriesignal zeigt, wie bereits erwähnt, die Symmetrie der Seitenbänder des im MPX-Signal enthaltenen Stereo-Hilfsträgers an. Dieser Stereo-Hilfsträger ist durch die Differenz der Audiosignale des linken und des rechten Stereokanals in Form einer Zweiseitenbandamplitudenmodulation mit unterdrücktem Träger moduliert. Eine Differenz der beiden Seitenbänder deutet auf im Audiosignal tatsächlich hörbare Störungen hin, so dass das Symmetriesignal als ein erstes, im empfangenen Audiosignal enthaltene Störungen anzeigendes Signal herangezogen wird. Ebenso deutet eine geringe Empfangsfeldstärke, die am Feldstärkesignal ablesbar ist, auf einen hohen Störgrad des empfangenen Audiosignals hin. Schließlich wertet die Störgraderkennungseinrichtung 43 auch das im MPX-Signal enthaltene digitale Informationssignal, nämlich das RDS-Signal zur Ermittlung des Störgrads des empfangenen Audiosignals aus. So ist die Datenfehlerrate des RDS-Signals ein Indiz für den Störgrad des empfangenen Audiosignals.

Die Störgraderkennungseinrichtung 43 kombiniert die beschriebenen Hilfssignale unter geeigneter Gewichtung zum Störsignal, das der Filtersteuerung 451 zugeführt ist.

Die Funktionsweise der Absenkungseinrichtung 45 und der Filtersteuerung 451 werden nachfolgend anhand der in den Figuren 2A, 2B und 2C dargestellten Beispiele näher erläutert.

Es wird nachfolgend davon ausgegangen, dass das am Ausgang des Stereodecoders 44 anstehende Audiosignal für den linken und den rechten Stereokanal in Form eines digitalen Signals vorliegt. Dies ist jedoch keinesfalls im Sinne einer Einschränkung auf eine digitale Signalverarbeitung zu verstehen. Das Filter 452 ist als digitales Filter mit steuerbaren Koeffizienten ausgeführt, wobei über eine geeignete Steuerung der Koeffizienten sowohl die Grenzfrequenz des als Tiefpass ausgeführten Filters, wie auch dessen Flankensteilheit oder/und maximale Dämpfung steuerbar sind. Die Filterkoeffizienten für das digitale Filter 452 werden in der Filtersteuerung 451 in Abhängigkeit des von der Störgraderkennungseinrichtung 43 gebildeten Störsignals und des den Amplitudenfrequenzgang des Equalizers 46 anzeigenden Frequenzgangsignals gebildet. Die Bildung der Filterkoeffizienten in der Filtersteuerung 451 erfolgt derart, dass eine durch die Klangbeeinflussungseinrichtung 46 und die Absenkungsvorrichtung 45 bestimmte Verstärkung des Audiosignals im Bereich der durch die Absenkungsvorrichtung 45 beeinflussten Frequenzanteile auf ein allein durch den erfassten Störgrad vorgegebenes Maß eingestellt wird.

Im Fall des in Figur 2B dargestellten Beispiels ist an der Klangbeeinflussungseinrichtung 46 für das wiederzugebende Audiosignal ein linearer Amplitudenfrequenzgang 466 mit der Verstärkung 1 eingestellt, so dass das wiederzugebende Audiosignal durch die Klangbeeinflussungseinrichtung 46 in diesem Fall nicht beeinflusst wird. Als Reaktion auf einen festgestellten Störgrad soll ein High-Cut gemäß dem Amplitudenfrequenzgang 476 durchgeführt werden, wobei das durch den Frequenzgang 476 bewirkte Maß der Höhenabsenkung durch den Störgrad vorgegeben ist und zur Verdeckung der Empfangsstörungen gerade ausreicht. Dazu wird am Filter 452 durch entsprechende Steuerung dessen Koeffizienten durch die Filtersteuerung 451 ein Amplitudenfrequenzgang 456 eingestellt, der in Verbindung mit dem Amplitudenfrequenzgang 466 der Klangbeeinflussungseinrichtung 46 den resultierenden Frequenzgang 476 ergibt. Im Fall des neutralen Amplitudenfrequenzgangs 466 der Klangbeeinflussungseinrichtung entspricht der Amplitudenfrequenzgang 456 des Filters 452 dem resultierenden Gesamtfrequenzgang 476.

Im Fall des in Figur 2A dargestellten Beispiels ist hingegen an der Klangbeeinflussungseinrichtung 46 ein Amplitudenfrequenzgang 465 vorgegeben, demzufolge hochfrequente Anteile des wiederzugebenden Audiosignals zu höheren Frequenzen hin zunehmend gedämpft werden. Um in diesem Falle den gleichen High-Cut-Effekt, wie im Fall der Figur 2B, also den resultierenden Gesamtamplitudenfrequenzgang 475 am ersten Ausgang 461 der Klangbeeinflussungseinrichtung 46, der ausschließlich vom Störgrad des empfangenen Audiosignals abhängig ist, für das wiederzugebende Audiosignal zu erzielen, werden die Filterkoeffizienten für das Filter 452 in der Filtersteuerung 451 derart gebildet, dass sich durch das Filter 452 ein schwächer ausgebildeter High-Cut-Effekt ergibt. Durch die Hintereinanderschaltung des Filters 452 und der Klangbeeinflussungseinrichtung 46 ergibt sich dann der resultierende Amplitudenfrequenzgang 475, so dass der Gesamtamplitudenfrequenzgang im Falle eines High-Cut im Bereich der durch den High-Cut beeinflussten Frequenzbereichs sich ausschließlich aus dem Störgrad des empfangenen Audiosignals ergibt.

Figur 2C zeigt schließlich ein Beispiel, in dem ein dritter Amplitudenfrequenzgang 467 an der Klangbeeinflussungseinrichtung 46 eingestellt ist, der sich dadurch auszeichnet, dass hochfrequente Anteile des wiederzugebenden Audiosignals zu höheren Frequenzen hin zunehmend verstärkt werden. Würde in diesem Fall ein High-Cut mit einem fest vorgegebenen Frequenzverlauf vorgenommen, ergäbe sich ein resultierender Frequenzverlauf, der eine nicht ausreichende Absenkung im Bereich hochfrequenter Anteile des wiederzugebenden Audiosignals aufwiese, infolge dessen Störungen im hochfrequenten Audiosignalbereich sich weiterhin bemerkbar machten.

Demzufolge steuert die Filtersteuerung 451 in Abhängigkeit des an der Klangbeeinflussungseinrichtung 46 vorgegebenen Amplitudenfrequenzgangs und des tatsächlich gemessenen Störgrads die Filterkoeffizienten derart, dass sich ein resultierender Amplitudenfrequenzgang 477 ergibt, der nur durch den Störgrad des empfangenen Audiosignals bestimmt ist. Dazu werden die Filterkoeffizienten des Filters 452 derart bestimmt, dass der Amplitudenfrequenzgang des Filters 452 gegenüber dem neutralen Fall der Figur 2B eine stärkere Absenkung der hochfrequenten Audiosignalanteile bewirkt. Diese stärkere Dämpfung hochfrequenter Signalanteile kompensiert die Höhenanhebung der nachgeschalteten Klangbeeinflussungseinrichtung 46, so dass sich der resultierende Amplitudenfrequenzgang 477, der eine optimale Dämpfung der hochfrequenten Signalanteile zur Unterdrückung hörbarer Störungen im Audiosignal bewirkt, ergibt.

Für den Fall einer analogen Audiosignalverarbeitung kann das digitale Filter 452 ersichtlich auch in Form eines analogen Filters ausgeführt sein. Auch eine solche Ausführungsform liegt im Bereich der vorliegenden Erfindung.

## Patentansprüche

1. Wiedergabevorrichtung für über potentiell störbehaftete Kanäle übermittelte Audiosignale mit
einer Einrichtung (43) zur Erfassung eines Störgrades der Audiosignale,
einer Einrichtung (45) zur Absenkung hochfrequenter Anteile der Audiosignale in Abhängigkeit des Störgrades
und einer Klangbeeinflussungseinrichtung (46) zur frequenzselektiven Verstärkung der Audiosignale,
**gekennzeichnet durch**
eine Ausbildung der Absenkungsvorrichtung (45) zur Absenkung der hochfrequenten Audiosignalanteile zusätzlich in Abhängigkeit einer mittels der Klangbeeinflussungeinrichtung (46) voreingestellten frequenzselektiven Audiosignalverstärkung.

2. Wiedergabevorrichtung nach Anspruch 1, **gekennzeichnet durch** eine Ausbildung der Absenkungseinrichtung (45) derart, daß eine **durch** die Klangbeeinflussungseinrichtung (46) und die Absenkungsvorrichtung (45) bestimmte Verstärkung des Audiosignals im Bereich der **durch** die Absenkungsvorrichtung (45) beeinflußten Frequenzanteile auf ein allein **durch** den erfaßten Störgrad vorgegebenes Maß eingestellt wird.

## Claims

1. Reproduction apparatus for audio signals transmitted over channels which are potentially subject to interference, having
a device (43) for detecting a degree of interference in the audio signals,
a device (45) for lowering radio-frequency components of the audio signals on the basis of the degree of interference,
and a tone-influencing device (46) for frequency-selective amplification of the audio signals,
**characterized by**
the lowering apparatus (45) being designed to lower the radio-frequency audio signal components additionally on the basis of a frequency-selective audio signal gain which has been preset using the tone-influencing device (46).

2. Reproduction apparatus according to Claim 1, **characterized by** the lowering device (45) being designed such that a gain, determined by the tone-influencing device (46) and the lowering apparatus (45), for the audio signal in the region of the frequency components influenced by the lowering apparatus (45) is set to a dimension which is prescribed solely by the degree of interference detected.

## Revendications

1. Dispositif de restitution pour des signaux audio transmis par des voies potentiellement perturbées avec
un dispositif (43) pour la saisie d'un degré de perturbation des signaux audio,
un dispositif (45) pour abaisser les proportions à haute fréquence des signaux audio en fonction du degré de perturbation,
et un dispositif d'influence du son (46) pour l'amplification sélective en fréquence des signaux audio,
**caractérisé par**
une conception du dispositif d'abaissement (45) pour abaisser les proportions à haute fréquence des signaux audio également en fonction d'une amplification, sélective en fréquence, des signaux audio préréglée au moyen du dispositif d'influence du son (46).

2. Dispositif de restitution selon la revendication 1,
**caractérisé par**
une conception du dispositif d'abaissement (45) de telle sorte qu'une amplification déterminée du signal audio par le dispositif d'influence du son (46) et le dispositif d'abaissement (45) est réglée, dans la gamme des proportions de fréquence influencées par le dispositif d'abaissement (45), à une mesure prédéterminée seulement par le degré de perturbation saisi.
